# FASCICULE DE BREVET EUROPEEN

(11) **EP 0 387 954 B1**
(45) Date de publication et mention de la délivrance du brevet: **16.06.1993**
(21) Numéro de dépôt: 90200565.1
(22) Date de dépôt: 12.03.1990
(51) Int. Cl.: H03H 7/12, H03G 5/02

(54) **Filtre passe-bande à largeur de bande ajustable**
Bandpassfilter mit einstellbarer Bandbreite
Pass-band filter with adjustable band-width

(30) Priorité: 17.03.1989 FR 8903523
(43) Date de publication de la demande: 19.09.1990
(73) Titulaire: PHILIPS ELECTRONIQUE GRAND PUBLIC, 92150 Suresnes (FR); Philips Electronics N.V., 5621 BA Eindhoven (NL)
(72) Inventeur: Letessier, Jacques, Societe Civile S.P.I.D., F-75007 Paris (FR); Castelli, Philippe, Societe Civile S.P.I.D., F-75007 Paris (FR)
(74) Mandataire: Caron, Jean

(56) Documents cités:
- PATENT ABSTRACTS OF JAPAN, vol. 8, no. 84 (E-239)[1521], 18 avril 1984; & JP-A-59 005 714 (MATSUSHITA DENKI SANGYO K.K.) 12-01-1984
- PATENT ABSTRACTS OF JAPAN, vol. 4, no. 97 (E-18)[579], 12 juillet 1980, page 126 E 18; & JP-A-55 061 118 (MITSUBISHI DENKI K.K.) 08-05-1980
- PATENT ABSTRACTS OF JAPAN, vol. 7, no. 21 (E-155)[1166], 27 janvier 1983; & JP-A-57 180 218 (OKI DENKI KOGYO K.K.) 06-11-1980
- PATENT ABSTRACTS OF JAPAN, vol. 7, no. 21 (E-155)[1166], 27 janvier 1983; & JP-A-57 180 217 (OKI DENKI KOGYO K.K.) 06-11-1982

## Description

La présente invention concerne un filtre passe-bande à largeur de bande ajustable, muni d'un élément capacitif monté en shunt à l'entrée, de deux branches inductives montées en série entre lesquelles est insérée, en un point dit central, une branche inductive montée en shunt, et d'un élément capacitif monté en shunt en sortie.

Un tel filtre est utilisé, par exemple, dans l'amplificateur à fréquence intermédiaire d'un récepteur de signaux de télévision en provenance d'un satellite. On désire ajuster la largeur de bande du signal avant démodulation, de manière à adapter cette largeur au rapport signal/bruit présent. Ceci doit pouvoir être fait sans toucher au gain de l'amplificateur, ni à la fréquence d'accord du filtre.

Si l'on cherche à modifier la bande passante en faisant varier les surtensions des inductances (dans des rapports différents pour ne pas changer la fréquence), alors le gain varie. Si l'on cherche à modifier la bande passante en changeant le couplage, par exemple par modification de la valeur d'un élément shunt, alors la fréquence d'accord varie. En général, il est extrêmement difficile de faire varier un paramètre sans affecter au moins un des autres. C'est probablement la raison qui a conduit, dans l'art antérieur, à utiliser deux filtres complètement distincts mis en oeuvre par commutation comme l'enseigne le document JP-Kokai-193416/82.

En fait, la demanderesse a constaté qu'il est possible de résoudre le problème à l'aide d'un seul filtre. Celui ci est remarquable en ce qu'une des deux branches inductives montées en série est dédoublée et comprend, en série à partir du point central, une première inductance et une deuxième inductance reliées en un point dit point commun, et une capacité est ajoutée dans la branche, en ce que la branche montée en shunt est divisée en deux inductances montées en série reliées en un point dit point de liaison, et en ce que deux interrupteurs dont l'un est ouvert quand l'autre est fermé sont montés, l'un entre le point commun et l'entrée, et l'autre entre le même point commun et le point de liaison.

Avantageusement, les interrupteurs sont constitués par des diodes, et une capacité d'isolation est insérée quelque-part dans la chaine des éléments placés entre le point commun et le point de liaison, afin de ne pas court-circuiter les diodes en courant continu.

L'utilisation de diode pour constituer des interupteurs est connue de Patent Abstracts of Japan; Vol. 8 no. 84 (E239) [1521], 18 avril 1984 et JP-A- 59 005 714

Le circuit selon l'invention est ainsi très remarquable dans la mesure où les résultats désirés sont atteints avec une grande économie de moyens, et notamment avec seulement deux interrupteurs.

La descrition qui va suivre, en regard des dessins annexés décrivant des exemples non limitatifs fera bien comprendre comment l'invention peut être réalisée.

La figure 1 est un schéma de filtre connu auquel s'applique l'invention.

La figure 2 est un schéma d'un filtre selon l'invention.

La figure 3 est le schéma équivalent du filtre de la figure 2, pour une position donnée des interrupteurs.

La figure 4 est le schéma éqivalent du filtre de la figure 2, pour une autre position des interrupteurs.

La figure 5 est un schéma de réalisation détaillé d'un filtre selon l'invention.

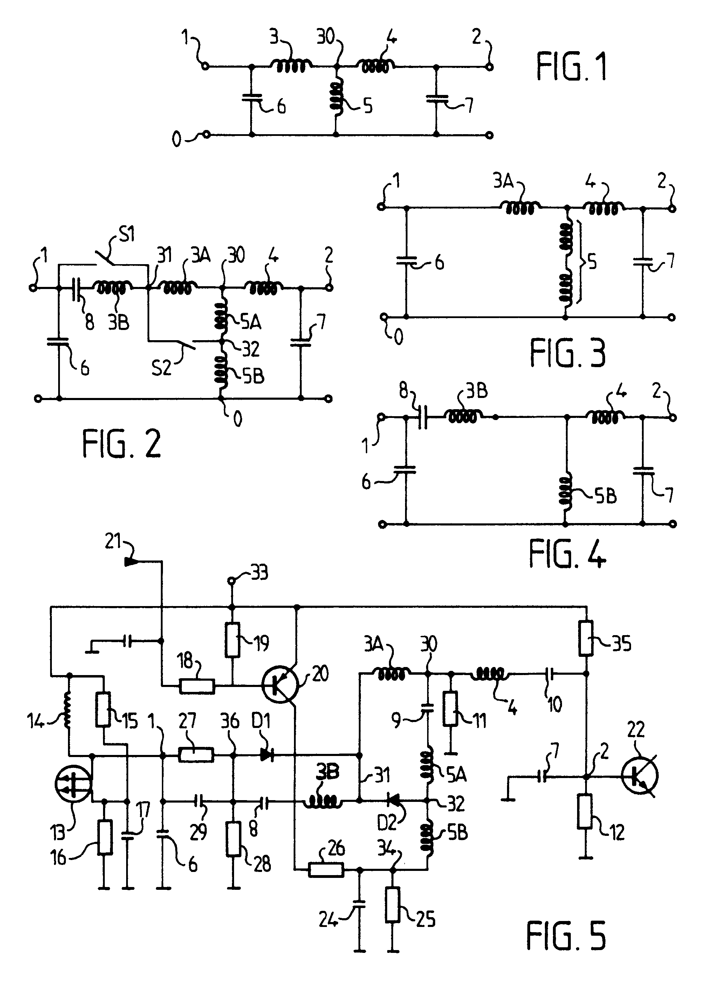

Le filtre passe-bande de la figure 1 , d'un genre bien connu, est muni d'un élément capacitif 6 monté en shunt à l'entrée, de deux branches inductives 3,4 montées en série entre l'entrée 1 et la sortie 2, entre lesquelles est insérée, en un point 30 dit point central, une branche inductive 5 montée en shunt, et d'un élément capacitif 7 monté en shunt en sortie.

Le filtre de la figure 2 dérive de celui de la figure 1 avec les modifications suivantes:
- la branche inductive 5 est divisée en deux parties 5A,5B montées en série avec entre elles un point de liaison 32,
- la branche inductive 3 est non pas divisée mais dédoublée (ce terme sera expliqué plus loin) en deux inductances placées en série à partir du point central 30 dans l'ordre respectif 3A,3B, avec entre elles le point commun 31,
- une capacité est insérée entre l'inductance 3B et l'entrée 1,
- un interrupteur S1 est placé entre le point commun 31 et l'entrée 1,
- un interrupteur S2 est placé entre le point commun 31 et le point de liaison 32.

Lorsqu'un des interrupteurs est fermé, l'autre est ouvert. La branche 4 n'est pas modifiée. Il faut noter que le problème résolu par l'invention pourrait être résolu aussi en appliquant à l'ensemble 4,7 les modifications apportées ici à l'ensemble 3,6, en laissant alors l'ensemble 3,6 non modifié.

La figure 3 représente le circuit équivalent lorsque l'interrupteur S1 est fermé, et l'interrupteur S2 ouvert. Ceci correspond à une bande passante large. Le circuit est identique à celui de la figure 1 dans lequel l'inductance 3 est remplacée par l'inductance 3A; la valeur de l'inductance 5A+5B est égale à la valeur de l'inductance 5. Cette dernière est donc divisée en deux inductances 5A,5B.

La figure 4 représente le circuit pour la position inverse des interrupteurs. Par rapport à la figure 1, l'inductance de couplage 5 est diminuée et il ne reste plus que la partie 5B: la bande passante est donc plus étroite. L'inductance 3 est remplacée par l'inductance 3B: dans aucune des configurations des figures 3 et 4, les deux inductances 3A,3B ne sont en série l'une avec l'autre: l'inductance 3 n'est donc pas divisée en deux mais dédoublée, chaque inductance 3A,3B étant à chaque fois utilisée seule. En série avec l'inductance 3B est placée une capacité 8; celle ci constitue, ensemble avec la capacité 6, une capacité d'accord différente de la capacité 6 de la figure 3, avec en plus une adaptation d'impédance différente du fait que l'entrée se fait sur une prise entre les deux capacités. Grâce à la modification de la valeur des autres éléments (3A→3B et 6→6+8), la fréquence centrale peut être maintenue, et grâce à l'entrée 1 amenée à une prise entre les capacités 6 et 8, le gain peut lui aussi être maintenu.

Il faut noter qu'en réalité les inductances 4 des figures 4 et 1 ne sont pas rigoureusement les mêmes, car les inductances 3A et 5A de la figure 2 sont en parallèle entre elles losque l'interrupteur S2 est fermé et réunit leurs extrémités respectivement 31 et 32, et ce groupe parallèle est lui même en série avec l'inductance 4. Toutefois ceci est quasiment négligeable car, comme on le verra plus loin, la valeur de l'inductance 5A est très inférieure à celle de l'inductance 4 et cet ajout à l'inductance 4 a un effet très faible. En outre cet effet très faible joue dans le bon sens, car la valeur de l'inductance 4 doit être un peu plus grande quand la bande étroite est en service, ce qui correspond justement au schéma de la figure 4.

On pourrait chercher à réaliser l'inductance 3 en la divisant au lieu de la dédoubler, c'est à dire au moyen d'une inductance de base et d'une inductance talon court-circuitable au moyen d'un interrupteur. Dans ce cas l'interrupteur S2 serait placé entre les points 30 et 32, l'inductance 3A étant constamment en service. Cette solution ne serait pas satisfaisante du fait que le circuit constitué par l'inductance talon 3B en série avec la capacité 8 constitue (en dessous de la fréquence d'accord) un élément capacitif qui, en parallèle avec l'inductance parasite de la diode constituant en pratique l'interrupteur S1 et qui serait alors conductrice, formerait un réjecteur dans la bande passante.

Le circuit complet de la figure 5 comprend les mêmes éléments 1, 2,8,3B,3A,5A,5B,4,30,31,32 que celui de la figure 2. Pour des raisons pratiques d'adaptation d'impédance, les capacités 6 et 7 des figures précédentes sont maintenant remplacées chacune par deux capacités en série, respectivement 6,29 et 7,10, de façon à constituer des diviseurs capacitifs. Le signal d'entrée du filtre est donc introduit entre les capacités 6 et 29, et le signal de sortie est prélevé entre les capacités 7 et 10.

Les interrupteurs sont ici constitués par deux diodes D1 et D2 connectées à la place des interrupteurs de la figure 2. Leurs cathodes sont réunies au point commun 31. Les autres éléments sont particuliers au mode de mise en oeuvre qui va être décrit et peuvent être modifiés sans changer quoi que ce soit à l'invention. Le montage est attaqué à l'entrée par un transistor 13 amplificateur à effet de champ à canal N, dont la source est polarisée par un pont de résistances 15,16 disposé entre l'alimentation 33 et la masse, avec une capacité de découplage 17. Le signal et amené à ses grilles par un circuit non représenté et qui ne fait pas partie de l'invention. Son drain est chargé par une inductance d'arrêt 14 reliée à l'alimentation, et fournit le signal à l'entrée 1 du filtre.

Une capacité 9 est ajoutée entre l'inductance 5A et le point central 30, afin que la diode D2 ne soit pas court-circuitée en courant continu par les inductances 5A et 3A; elle pourrait aussi bien être placée entre l'inductance 5A et le point 32. De même, la capacité 10 du divideur d'adaptation d'impédance, placée en série avec l'inductance 4, sert aussi à l'isolation galvanique. Une résistance 27 est introduite en parallèle avec la capacité 29: elle relie en courant continu l'anode de la diode D1 , via l'inductance 14, à l'alimentation 33 ; elle influence très peu le comportement du filtre, car son impédance est très supérieure à celle de la capacité 29. La résistance 11 relie à la masse, en courant continu, les cathodes des diodes. Les résistances 27 et 28 constituent en courant continu un pont entre l'alimentation 33 et la masse, dont le point milieu 36 fixe la tension continue à l'anode de la diode D1.Les résistances 12 et 35 établissent la polarisation de la base du transistor NPN amplificateur de sortie 22.

Le transistor PNP 20, d'un type basse fréquence ordinaire, sert à la commande de tension de polarisation des diodes servant d'interrupteurs D1,D2. Sa base est reliée au point commun d'un groupe de deux résistances en série 19,18 respectivement reliées à l'alimentation et à une borne 21 de commande de largeur de bande. L'émetteur du transistor 20 est relié à l'alimentation 33. Son collecteur est relié à la masse par un pont de résistances 26,25 avec un point milieu 34, découplé à la masse par une capacité 24.

Il est nécessaire que la valeur des résistances des ponts 25,26 et 28,27 soit telle que, lorsque le transistor 20 est conducteur, la tension au point 34 soit plus élevée d'au moins 0,8 volt que celle au point commun des résistances 27,28. Alors la diode D2 est conductrice et la tension de sa cathode est plus élevée que celle de l'anode de D1 qui est donc bloquée. Quand le transistor 20 est bloqué, le point 34 et donc l'anode de D2 sont à la masse via la résistance 25; la diode D1 est conductrice et sa cathode est donc portée à une tension plus élevée que la masse, ce qui bloque D2.

Dans l'exemple décrit ci dessus, les valeurs indiquées dans le tableau in fine ont été retenues, pour les éléments essentiels du filtre qui constitue l'un des éléments de filtrage prévus dans un amplificateur à fréquence intermédiaire à 480 MHz destiné à la réception d'une émission de télévision en D2-MAC/paquet.

La réalisation est faite de préférence en circuit imprimé en essayant d'obtenir une grande compacité. Les inductances 3A,3B,4, et la self d'arrêt 14 sont des éléments discrets rapportés, alors que les inductances 5A,5B de plus petite valeur sont constituées par des sections de piste imprimée. Les capacités et les résistances sont des modèles miniatures pour montage en surface. Les valeurs retenues pour les inductances ne sont pas exactement celles fournies par la théorie, car elles tiennent compte des inductances parasites des capacités d'isolation.

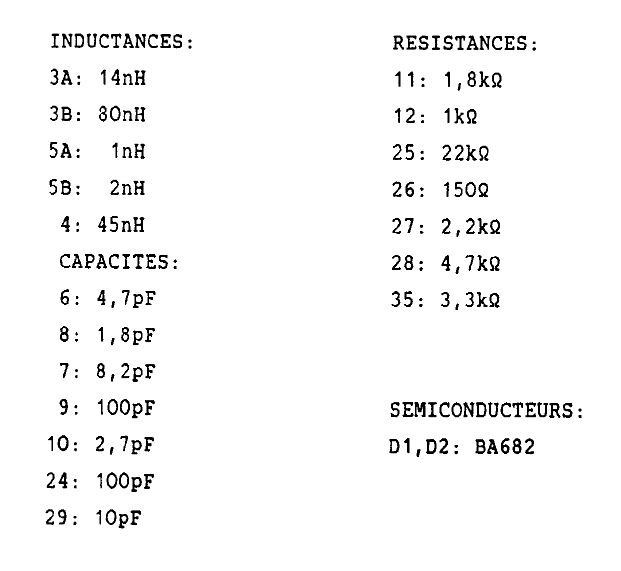

## Revendications

1. Filtre passe-bande à largeur de bande ajustable, muni d'un élément capacitif monté en shunt à l'entrée (6), de deux branches inductives montées en série (3a,3b,4) entre lesquelles est insérée, en un point dit central (30), une branche inductive montée en shunt (5), et d'un élément capacitif monté en shunt en sortie (7), caractérisé en ce qu'une des deux branches inductives montées en série est dédoublée et comprend en série à partir du point central une première inductance (3a) et une deuxième inductance (3b) reliées en un point dit point commun (31), et une capacité est ajoutée en série avec l'inductance dans la branche, en ce que la branche montée en shunt est divisée en deux inductances (5a,5b) montées en série reliées en un point dit point de liaison (32), et en ce que deux interrupteurs (S1,S2) dont l'un est ouvert quand l'autre est fermé sont montés, l'un entre le point commun et l'extrémité de la susdite branche dédoublée (S1) qui est à l'opposé du point central (30), et l'autre (S2) entre le même point commun et le point de liaison (52).

2. Filtre passe-bande selon la revendication 1, caractérisé en ce que les interrupteurs sont constitués par des diodes (D1,D2), et en ce qu'une capacité d'isolation (9) est insérée dans la chaine des éléments inductifs placés entre le point commun et le point de liaison (32)

## Patentansprüche

1. Bandpaßfilter mit einstellbarer Bandbreite, mit einem kapazitiven Element im Nebenschluß zu dem Eingang (6), mit zwei reihengeschalteten induktiven Zweigen (3A, 3B,4), zwischen denen ein induktiver Zweig (5) zu einem zentralen Punkt (30) im Nebenschluß liegt und wobei ein kapazitives Element zu dem Ausgang (7) im Nebenschluß liegt, dadurch gekennzeichnet, daß einer der beiden reihengeschalteten induktiven Zweige verdoppelt ist und von dem zentralen Punkt aus in Reihe eine erste Induktivität (3A) und eine zweite Induktivität (3B) aufweist, die an einem gemeinsamen Punkt (31) miteinander verbunden sind, sowie einen mit der Induktivität in Reihe liegenden Kondensator, der in dem Zweig hinzugefügt ist, daß der im Nebenschluß geschaltete induktive Zweig in zwei reihengeschaltete mit einem gemeinsamen Punkt (32) verbundene Induktivitäten (5A, 5B) aufgeteilt ist, und daß zwei Schalter (S1, S2), von denen der eine offen ist, wenn der andere geschlossen ist, vorgesehen sind, wobei der eine Schalter (S1) zwischen dem gemeinsamen Punkt (30) und dem Ende des genannten Zweiges und der andere Schalter (S2) zwischen demselben gemeinsamen Punkt und dem Verbindungspunkt (52) liegt.

2. Bandpaßfilter nach Anspruch 1, dadurch gekennzeichnet, daß die Schalter durch Dioden (D1, D2) gebildet sind und daß der Isolierkondensator (9) in den Zweig der zwischen dem gemeinsamen Punkt und dem Verbindungspunkt (32) liegenden induktiven Elemente eingefügt ist.

## Claims

1. A bandpass filter having an adjustable band-width, comprising a capacitive element arranged in shunt across the input (6), two series-arranged inductive branches (3A, 3B, 4) between which a shunting inductive branch (5) is arranged at a central point (30), and a capacitive element arranged in shunt across the output (7), characterized in that one of the two series-arranged inductive branches is duplicated and comprises in series from the central point a first inductance (3A) and a second inductance (3B) interconnected at a common point (31), and a capacitor which is added in series with the inductance in the branch, in that the shunting inductive branch is divided into two series-arranged inductances (5A, 5B) interconnected at a connection point (32) and in that two switches (S1, S2) one of which is open when the other is closed are arranged, one switch between the common point and the extremity of said duplicated branch (S1) arranged opposite the central point (30) and the other switch (S2) between the same common point and the connection point (52).

2. A bandpass filter as claimed in Claim 1, characterized in that the switches are constituted by diodes (D1, D2) and in that an isolation capacitor (9) is arranged between the circuit of inductive elements between the common point and the connection point (32).
